Europäisches Patentamt

(19) European Patent Office

Office européen des brevets

(11) Publication number: **0 359 513**
A2

## (12) EUROPEAN PATENT APPLICATION

(21) Application number: 89309232.0

(22) Date of filing: 12.09.89

(51) Int. Cl.5: **H 01 L 23/64**
H 01 L 23/498

(30) Priority: 14.09.88 JP 231161/88

(43) Date of publication of application:
21.03.90 Bulletin 90/12

(84) Designated Contracting States: DE FR GB NL

(71) Applicant: HITACHI, LTD.
6, Kanda Surugadai 4-chome Chiyoda-ku
Tokyo (JP)

(72) Inventor: Suzuki, Hideo
2918-3 Katsukura
Katsura-shi Ibaraki-ken (JP)

Shinohara, Hiroichi
3-8-18, Kokubu-cho
Hitachi-shi Ibaraki-ken (JP)

Ogihara, Satoru
1-15-7 Minamikohya-cho
Hitachi-shi Ibaraki-ken (JP)

Nakanishi, Keiichirou
3-14-13 Honda-Kokubunji-shi
Tokyo (JP)

(74) Representative: Paget, Hugh Charles Edward et al
MEWBURN ELLIS 2 Cursitor Street
London EC4A 1BQ (GB)

(54) Semiconductor chip carrier and method of making it.

(57) A semiconductor chip carrier for carrying a single chip (15) and having a built-in capacitor, comprises a ceramic insulator body (2) having first and second opposite main faces, and a plurality of conductor lines (6,7) comprising power lines, ground lines and signal lines for forming connections to said chip extending through said ceramic body (2) from one main face to the other. A layer (3) of ceramic dielectric material is embedded in said ceramic body remote from said main faces, and electrode layers embedded in the ceramic body (2) contact the capacitor layer (3), to form the built-in capacitor. The power and ground lines (16) pass through and contact the capacitor layer (3) and are connected to said electrodes so that said capacitor provides capacitance between the power lines and the ground lines. To minimize noise generation and improve signal processing speed, the signal lines (7) do not contact said capacitor layer (3) and extend past it at locations spaced laterally from it.

FIG. 2

EP 0 359 513 A2

## Description

## SEMICONDUCTOR CHIP CARRIER AND METHOD OF MAKING IT

The present invention relates to a carrier for carrying a single semiconductor chip, and to a semiconductor module provided with at least one such carrier. Particularly the carrier is useful for semiconductor devices suitable for an electronic computer, for which a high transmission speed of signals is required.

Recently, there has been a strong demand for miniaturization of electronic equipment and electronic devices by employing semiconductor chips such as IC's and LSI's. Accordingly, high-density substrates for packaging chips have been developed. The substrate should include resistors and capacitors so that the size of the semiconductor module is minimized.

US-A-4,349,862 (corresponding to JP-A-82-37818) discloses a ceramic carrier for chips, in which arrays of capacitor elements are located between pairs of metallized glass ceramic laminating materials. Each capacitor element is a small area of dielectric material and has a pair of correspondingly sized electrodes, connected to conductor lines passing through the carrier at locations spaced from the capacitor elements. Since these capacitor elements must be formed by printing the capacitor elements and electrodes, a capacitor of high dielectric material is difficult to obtain.

JP-A-85-177696 discloses a chip substrate ceramic chip carrier comprising layers of dielectric ceramic material and insulator ceramic material laminated into one body. This is a composite ceramic substrate in which at least one of a resistor, a capacitor and a signal circuit and a power source circuit are provided. Packaging pads for electrical elements are provided on both surfaces of the substrate. The large electrode patterns connected to the power and ground conductors mean that a composite ceramic substrate with excellent noise-reducing capability has been realised. However, the capacitor layer extends over the whole area of the substrate, so that noise propagation to signal conductors remains a problem. This problem of noise induced in signal lines due to power/ground signals, when two or more devices operate simultaneously, has recently been noticed. The present invention seeks to solve it as discussed further below.

JP-A-86-47961 discloses a composite ceramic substrate, wherein independent capacitor elements are moulded in one body with conductor wiring which electrically connects the capacitor elements to external electrodes, using insulating ceramics. The humidity-proof characteristic of the substrate is improved by sealing. This document is not concerned with the connection of conductor lines to a semiconductor chip.

JP-A-87-211995 discloses a method of manufacturing a ceramic circuit board comprising capacitors, by the steps of printing an electrode layer and a dielectric layer on an opposed pair of ceramic green sheets, laminating ceramic green sheets and sintering them in one body. Again this document si not concerned with connections in chip carriers.

The prior art documents described so far aim to minimize the size of the equipment by providing a resistor and a capacitor within the substrate. However, the computing speed required particularly for a large-scale electronic computer is not taken into consideration in these documents.

High packaging density, minimization of sizes, and increase in computing speed have been required for electronic equipment, particularly for a large-scale electronic computer. The acceleration of computing speed in an electronic computer increases the number of logic circuits which are switched simultaneously. However, noise that impairs signal speed is generated by simultaneous switching. To reduce noise generated by the simultaneous switching, a capacitor is incorporated into a circuit.

In the prior art structures, increase of signal transmission speed is limited because the dielectric used to form a capacitor makes contact with a signal conductor in which an electrical signal is transmitted, or because the capacitor is connected to power and ground conductors via wiring embedded in an insulator. In such structures, therefore, the electrical signal is delayed when transmitted through a high dielectric. Alternatively, inductive effects in the wiring connecting the capacitor to the power and ground lines increase noise. The acceleration of computing speed made possible by providing a capacitor is thus limited.

It is an object of the present invention to provide a semiconductor chip carrier for a single chip which incorporates a capacitor without causing a deterioration of signal transmission speed. It is another object to provide a method of manufacturing such a carrier.

In one aspect, the present invention provides a semiconductor chip carrier for carrying a single chip and having a built-in capacitor, comprising

a) a ceramic insulator body having first and second opposite main faces,

b) a plurality of conductor lines comprising power lines, ground lines and signal lines for forming connections to said chip when the latter is mounted on one of said main faces, each of said conductor lines extending through said ceramic body from one said main face to the other,

c) at least one capacitor layer of ceramic dielectric material embedded in said ceramic body remote from said main faces,

d) electrode layers embedded in said ceramic body and contacting said capacitor layer, to form said built-in capacitor. The carrier is characterized in that the power and ground lines pass through and contact said capacitor layer and are connected to said electrodes so that said capacitor provides capacitance between the power lines and the ground lines. While the signal lines do not contact said capacitor layer and extend past it at locations spaced laterally from it. The power and ground conductors are connected respectively to opposite electrodes of the capacitor. Preferably the chip carrier has no circuitry, apart from the capacitor, and the conductors in it are straight.

Preferably there is a single capacitor layer only, and preferably there are two electrodes only, respectively on opposite faces of the single capacitor layer.

Preferably, the power and ground lines on the one hand and the signal lines on the other hand are grouped into respective zones as seen in plan view looking onto one said main face such that one of the following arrangements (a) and (b) applies

a) the power and ground line zone is a central zone of the carrier surrounded by the signal line zone

b) the signal line zone is a central area of said carrier surrounded by the power and ground line zone.

In one embodiment, the ceramic insulator body comprises a ceramic glass and sintered barrier layers are provided on each face of said capacitor layer to prevent diffusion of components of the dielectric layer into the ceramic glass during firing of the chip carrier.

The invention further provides a semiconductor chip carrier as described above having a single semiconductor chip mounted thereon and connected to said conductor lines. The chip may be mounted on the carrier by solder elements which make direct connection between electrodes of the chip and the conductor lines of the carrier at one main face of the carrier.

The chip may be hermetically enclosed by a ceramic housing sealed to the chip carrier.

Yet further, the invention provides a semiconductor apparatus having a semiconductor wiring circuit board carrying a plurality of semiconductor chips, wherein each said chip is individually mounted on the circuit board by a semiconductor chip carrier as described above. Thus each carrier has a single chip on it.

In another aspect, the invention provides a method of manufacture of a semiconductor chip carrier for carrying a single chip and having a built-in capacitor comprising assembling and co-firing a plurality of green sheets of ceramic material having through-holes filled with conductive material to form conductor lines in the finished carrier. The green sheets comprise

(a) at least one green sheet of dielectric material which in the fired carrier forms a capacitor layer of said capacitor,

(b) at least two green sheets of insulator material embedding said at least one green sheet of dielectric material and having a larger area than said at least one green sheet of dielectric material, whereby some of said conductor lines which are to be signal lines do not contact said dielectric material, There is electrode-forming material embedded in the assembled green sheets adjacent green sheet or sheets of dielectric material to form electrodes of said capacitor.

Preferably the green sheet or sheets of dielectric material are located in the assembled green sheets remote from the edges of the green sheets of insulating material.

The invention furthermore provides combinations of green sheets, for use in manufacturing a semiconductor chip carrier for carrying a single chip and having a built-in capacitor, as described above.

In this invention, the signal conductors do not pass through the capacitor, but the power and ground conductors do pass through the capacitor. This means that the electrical signals pass only through the portion with a low dielectric constant, whereby the acceleration of the signal transmission velocity is made possible. On the other hand, the loss of capacitance can be reduced because the power and ground conductors are directly in contact with the dielectric of the capacitor, whereby the electric signal waveform is improved and the amount of noise is reduced.

Embodiments of the invention will now be described by way of non-limitative example, with reference to the accompanying drawings, in which:-

Figs. 1A-1D are process diagrams showing the manufacturing process for the semiconductor chip carrier of Fig. 2 embodying the present invention;

Fig. 2 is a sectional view showing a semiconductor device embodying the present invention, comprising a chip, a carrier and a housing for the chip;

Fig. 3 is an enlarged sectional view of part of Fig. 2;

Fig. 4 is a graph correlating the spacing of the conductor and the capacitance between the conductor and an electrode in Fig. 3;

Fig. 5 is a sectional view showing another semiconductor device embodying the invention, comprising a chip, a carrier and a housing for the chip;

Fig. 6 is a sectional view showing part of a semiconductor module according to the present invention, having a plurality of chips and chip carriers;

Fig. 7 is a perspective view, partly cut-away showing the module of Fig. 6;

Fig. 8 is a perspective view showing a computer package having a plurality of modules of Figs. 6 and 7;

Fig. 9 shows a plurality of green sheets, ready for firing to produce the chip carrier of Fig. 10; and

Fig. 10 is a sectional view of a further semiconductor chip carrier embodying the invention.

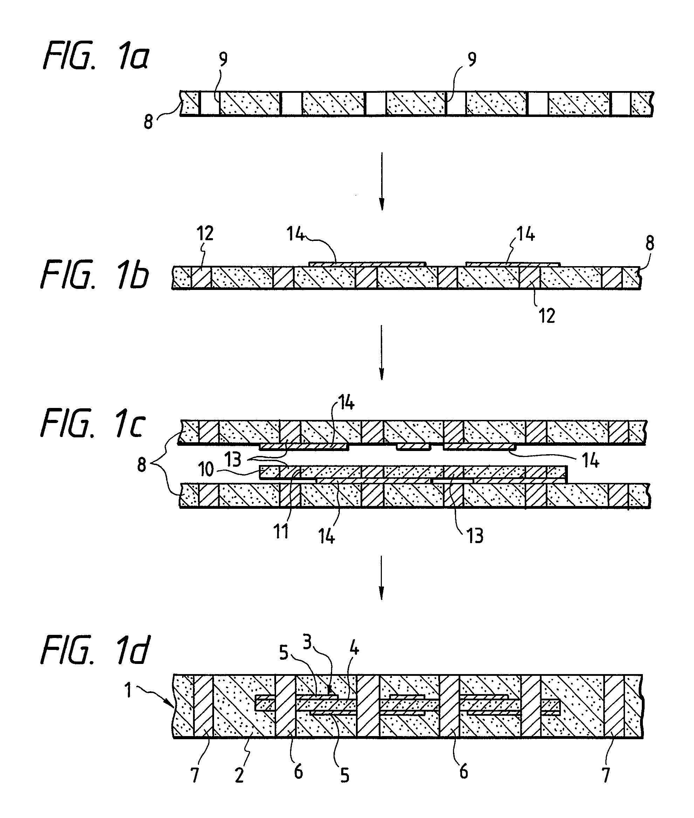

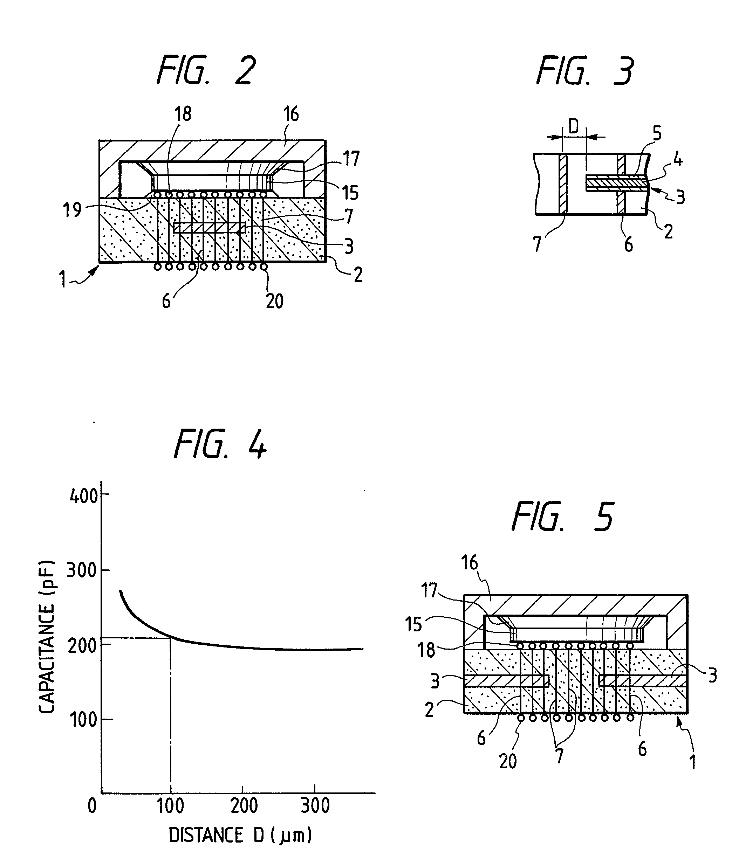

Fig. 1 shows a method of manufacturing a single chip carrier 1 according to the invention, shown in Figs. 2 and 3. Fig. 1d and Fig. 2 show that in the carrier 1 a capacitor 3 is located within a body of ceramic insulating material 2. The capacitor 3 consists of a dielectric 4 and electrodes 5. The capacitance of the capacitor 3 is preferably from 0.01 to 1 μF, and its function is that of reducing noise. A capacitance of less than 0.01μF may be insufficient to reduce noise. A capacitance of up to 1μF or even

more is preferable for achieving a good noise reduction, but about 1µF is thought to be a present practical upper limit.

The dielectric 4 of the capacitor 3 is a material with a high dielectric constant to provide the capacitance of the capacitor portion. A capacitor material with dielectric constant of not more than 500 can of course be used, but the capacitance may be not more than 0.01 µF when the number of layers is small, which means that sufficient noise reduction may not be achieved. The capacitance can be increased by increasing the number of layers. However, it becomes difficult to manufacture the capacitor with material of a low dielectric constant if the number of layers is five or more. Therefore, in the invention the dielectric 4 is preferably made of a material with dielectric constant from 500 to 20,000, the higher values being better, and a dielectric constant of 20,000 or more is of course desirable. The dielectric constant of the insulating material for the layer 2 is preferably from 3 to 6 to maintain a high signal transmission velocity.

A plurality of power and ground conductors 6 (four are shown in Fig. 1) pass straight through the body of insulating material 2 at the position where the capacitor 3 is located. The conductors 6 are in direct contact with the dielectric 4 of the capacitor 3 and are connected to the electrodes 5. A plurality of signal conductors 7 pass straight through the body of insulating material 2 outside the region where the capacitor 3 is located.

In practice a large number of power and ground conductors 6 and signal conductors 7 is used, but this is not shown in the drawings, for clarity. Preferably there are at least 100 of each, and there may be more than 200 of each.

The manufacturing steps shown in Fig. 1 will now be described. First, a plurality of perforations or holes 9 are made in a green sheet 8 of ceramic insulating material. Some of the holes 9 are for signal conductors and others are for power and ground conductors. Similarly perforations 11 for the power and ground conductors are made in a green sheet 10 of dielectric material which has a smaller area than the sheet 8. The holes 9 and 11 are filled in the green sheets 8 and 10 with conductive pastes 12 and 13. A metal pattern 14 which serves as an electrode 5 of the capacitor is printed on the green sheet 8. At least two, and optionally more, identical green sheets 8 are manufactured to make a laminated layer, with two carrying electrode patterns 14. The dielectric green sheet 10 is held between the two green sheets 8 carrying electrodes, with the position of each perforation on the sheets adjusted so that the conductor pastes 12 and 13 are aligned on the same axis. The green sheets 8 and 10 are connected by hot pressing to make the carrier substrate 1.

As Fig. 1 shows, each conductor 6 contacts one of the two electrodes 5 of the capacitor, depending on whether it is a power conductor or a ground conductor. The capacitor thus provides the desired capacitance between the power conductors and the ground conductors. Preferably this is a single electrode 5 on each face of the dielectric layer 4. The thickness of the layer 4, after firing, is preferably less than 100 µm, more preferably 30-50µm.

One preferred material for the dielectric layer 4 is $PbTiO_3.Pb(Nb_{1/2}Fe_{1/2})O_3.Pb(Fe_{1/2}W_{2/3})O_3$, which is used in the specific embodiments given below. Two particularly preferred ceramic materials for the insulator body 2 are used in these specific embodiments. They are

(i) a $Bi_2O_3.SiO_2$ based glass, with $Al_2O_3$ filler

(ii) a $MgO.CaO.SiO_2.Al_2O_3$ based glass, with $Al_2O_3$ filler.

In order to avoid problems arising from different shrinkage behaviour of adjacent layers during firing, it is preferred to choose materials for the insulating green sheets and the dielectric green sheet or sheets such that all the green sheets have (a) approximately the same temperatures of starting and finishing shrinkage during firing and (b) approximately the same amount of shrinkage.

Specific examples are now described, with reference to Figs. 1 to 3. "PHR" means parts by weight and "%" means % by weight.

EMBODIMENT 1

The insulating green sheets are prepared as follows.

A slurry is prepared to make a green sheet. The materials comprising the slurry are: a glass powder with an average particle diameter of 5 µm, containing 9-15% MgO, 0-5% CaO, 35-45% $Al_2O_3$, and 40-55% $B_2O_3$, in total 100%, calculated as oxides; and an $SiO_2$ powder with an average particle diameter of 1µm. The glass powder and the $SiO_2$ powder are blended at a ratio of 95-40% to 5-60%. Added to the blended powder are 20PHR binder, 124PHR trichloroethylene, 32PHR tetrachloroethylene, 44PHR n-butylalcohol. Then the materials are subjected to 24 hours of wet mixing in a ball mill to form the slurry. The slurry is adjusted to a suitable viscosity by vacuum deaeration treatment.

The slurry is applied to a polyester film coated with silicone by a doctor blade method to 0.5mm thickness, and is then dried to make a green sheet 8 of the insulating material.

A green sheet 10 of 50 µm thickness made of dielectric material is formed in a similar manner. The dielectric material used is a ceramic with a dielectric constant of nearly 10,000, the main constituents of which are PbO, $Fe_2O_3$, $WO_3$, $TiO_2$ and $Nb_2O_3$.

As shown in Fig. 1, holes 9 of 100µm diameter are made in the insulating material green sheets 8, and holes 11 of 100µm diameter are made in the dielectric green sheet 10.

Ag-Pd conductor pastes 12 and 13 containing 15-30% Pd with a suitably adjusted viscosity are filled into the holes 9 and 11. A pattern serving as an electrode 14 of the capacitor is printed on the central area of the green sheet 8 corresponding to the sheet 10 using Ag-Pd conductor paste containing 15-30% Pd. The dielectric green sheet 10 is held between the central areas of two of the green insulating sheets 8, and then the plurality of insulating green sheets 8 in which the Ag-Pd condcutor paste is present are laminated, and then joined by hot pressing. The conditions for pressure joining are a temperature of 100°C and a pressure of 10kgf/cm². The laminated plate made by the above process is subjected to a temperature rise at a rate of not more than 100°C/h for removal of the binder at 500°C for three hours, and then subjected to a temperature rise at a rate of 200°C/h, and fired at 900-1000°C. The firing atmosphere is air.

The carrier is 1 mm thick and the conductors 6,7 are of 80μm diameter in this embodiment. The electrostatic capacity of the capacitor 3 formed at the centre of the carrier substrate 1 is approximately 0.1μF. The dielectric layer 4 is 40μm thick. No cracking or peeling is found adjacent to the built-in capacitor 3. No warp or deformation is found in the carrier 1.

The signal lines 7 in the carrier substrate 1 do not pass through the dielectric layer of the capacitor 3. If the carrier with a capacitor located over the entire area of the carrier and in contact with the through holes of the signal wiring is taken as standard (100%), the signal transmission velocity can be increased by 10% in this embodiment of the invention.

EMBODIMENT 2

The Ag-Pd conductor paste is filled in through holes of the insulating green sheet 8 made in embodiment 1, and is printed as the pattern to serve as an electrode for capacitor 3. After drying of the green sheet 8, a dielectric paste made from the dielectric powder used in embodiment 1 is printed onto it. This green sheet is held between other green sheets 8 and a plurality of sheets is laminated, joined by hot pressing, and fired at 900-1000°C as in Fig. 1. The firing atmosphere is air.

The electrostatic capacity of the capacitor 3 formed inside the carrier substrate is approximately 0.2μF and the thickness of the dielectric 4 is 20μm. No cracking or peeling is found adjacent to the built-in capacitor. No warp and deformation is found in the carrier. The signal transmission velocity can be increased by 18% in this embodiment, compared with the corresponding carrier in which the dielectric layer extends over the full area of the carrier and contacts the signal conductors.

EMBODIMENT 3

The materials comprising the slurry for the insulating sheets are: a glass powder with an average particle diameter of 5μm, containing 70-80% $SiO_2$, 10-20% $B_2O_3$, 0-0.2% $Al_2O_3$, 0-5% $K_2O$ and 0-0.2% ZnO, in total 100%, calculated as oxide; and an $Al_2O_3$ powder with an average grain diameter of 1μm. The glass powder and the $Al_2O_3$ powder are blended at a ratio of 90-60% to 10-40%. To the blended powder are added 20 PHR phthalic acid binder, 124 PHR trichloroethylene, 32 PHR tetrachloroethylene, and 44 PHR n-butylalcohol. And then the materials are subjected to 24-hours wet mixing to make the slurry. A green sheet 8 is made in a similar manner to embodiment 1.

An Ag-Pd conductor paste is filled into the through holes and an electrode is printed. The dielectric green sheet as made in embodiment 1 is held between green insulating sheets as in embodiment 1, and the laminate is joined by hot pressing, and fired at 900-950°C. The firing atmosphere is air.

In this case, the electrostatic capacity of the capacitor formed at the center of the carrier substrate is approximately 0.1μF and the dielectric layer is 40μm thick. No cracking or peeling is found adjacent to the incorporated capacitor. The signal transmission velocity can be increased by 10% in this embodiment, compared with the corresponding carrier in which the dielectric extends over the whole area and contacts the signal conductors.

EMBODIMENT 4

The through holes are filled and electrodes are formed using a gold paste instead of the Ag-Pd conductor paste used in embodiments 1-3. No cracking or peeling is found adjacent to the built-in capacitor. A ceramic carrier substrate incorporating a capacitor with highly reliable migration properties is realised by using gold. If a carrier with the dielectric in contact with the signal line is taken as a standard, the delay time can be reduced by 10-18%, and the signal transmission velocity is increased by 10-18% in this embodiment.

Fig. 2 shows an LSI chip 15 mounted on the carrier 1 made as shown in Fig. 1 and hermetically sealed by a housing 16. A heat transfer block 17 is provided between the LSI chip 15 and the housing 16, so that heat generated by the LSI chip 15 is radiated. The housing 16 may be provided with a passage for refrigerant, which is not shown. The LSI chip 15 is connected to the conductors 6 and 7 of the carrier substrate 1 by solder terminals 18 and the solder region is fixed within a resin layer 19. A soldering terminal 20 on the other surface of the carrier substrate 1 is provided at the ends of each conductor 6 and 7 to be connected to another module substrate.

A single LSI chip 15 is mounted on one carrier 1 which is not able to hold more than one chip. The capacitor 3 is located at the central area only of the carrier substrate 1. The power and ground conductors 6 are grouped at this central area of the carrier 1, and the signal conductors 7 are grouped at the outer area of the carrier 1 surrounding the central area. The signal conductors 7 do not pass through the dielectric layer of the capacitor 3. Since the capacitor 3 is provided at the core of the carrier substrate 1, the distance between the dielectric 4 and the LSI chip 15 can be reduced and a remarkable reduction in noise is achieved.

The distance D (Fig. 3) from each signal conductor 7 of the carrier 1 to the end surface of the capacitor 3 i.e. the nearest electrode 5, is at least 50μm, preferably 100μm or more. Fig. 4 shows how the capacitance (in fF) between a signal line 7 and the nearest electrode 5 typically varies with the distance D. To achieve a capacitance of less than 0.25 pF, this distance D should be at least 50μm. Fig. 4 is a computer simulation, assuming that the dielectric constant of the insulator 2 is infinite, the dielectric constant of the layer 2 is 5 and the thickness of the layer 4 is 30 μm.

Fig. 5 shows another embodiment in which, as seen in plan view, the capacitor 3 is located at a peripheral zone extending around the periphery of the carrier 1, and the power and ground conductors 6 are located at this peripheral zone which surrounds a central zone at which the signal conductors 7 are located. In other respects, this embodiment is the same as that of Fig. 2.

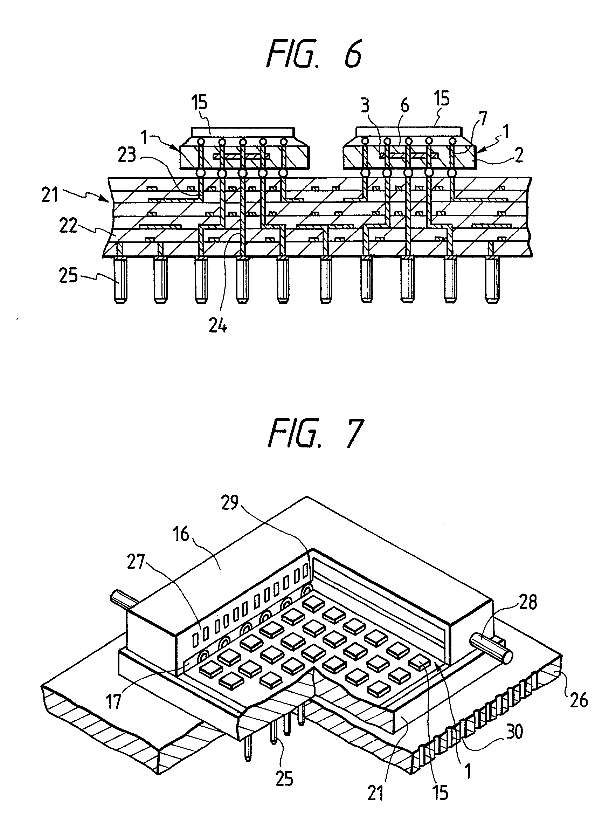

Fig. 6 shows part of a semiconductor module according to the present invention, having a plurality of carriers 1 as described above, each carrying a single chip 15 and connected to a module substrate 21 by soldering terminals 20. The module substrate is a multi-layer circuit board formed by laminating layers of insulating material 22. Only a few wiring connections are shown, for clarity. Within the module substrate 21, are signal conductors 23 and power conductors and ground conductors 24. Exterior connections are via input pins 25. The semiconductor module substrate 21 is mounted on a multi-layer print board 26 by the input pins 25 as shown in Fig. 7. The pins 25 are received in through holes 30.

In Fig. 6 the chips 15 are not covered by individual housings as in Fig. 2, but as shown in Fig. 7 are all enclosed by a single housing 16 sealed to the substrate 21. The housing 16 has a large number of coolant passages 27 and a coolant inlet 28. Thermal transfer discs 29 contact the individual chips 15 to establish good heat flow.

In the carrier 1 for a semiconductor chip, the area of the carrier occupied by the capacitor is preferably within the range 40-60%, as seen in plan view, to achieve effective operation of the LSI. Furthermore, when the chip 15 is mounted, the capacitor layer 4 preferably overlaps 30 to 70% of the chip area (as seen in plan view), more preferasbly 40 to 60%. Although there may be several power sources for driving the LSI, noise can be substantially reduced by providing the capacitor with power source electric potential and an earth electric potential for each power source independently.

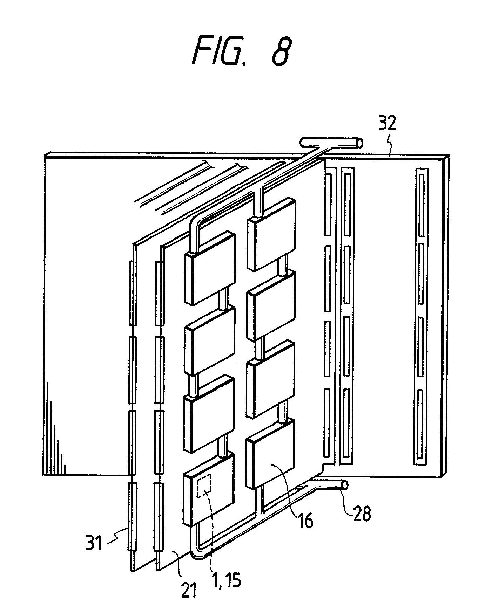

Fig. 8 shows a computer package device according to the present invention. The module substrate 21 of the several semiconductor modules as shown in Fig. 7 is made in one body and is electrically connected to a back board 32 by connectors 31. With this structure employing the invention, simultaneous changeover noise can be effectively reduced, and the computing velocity of a large-scale computer can be accelerated by 10%.

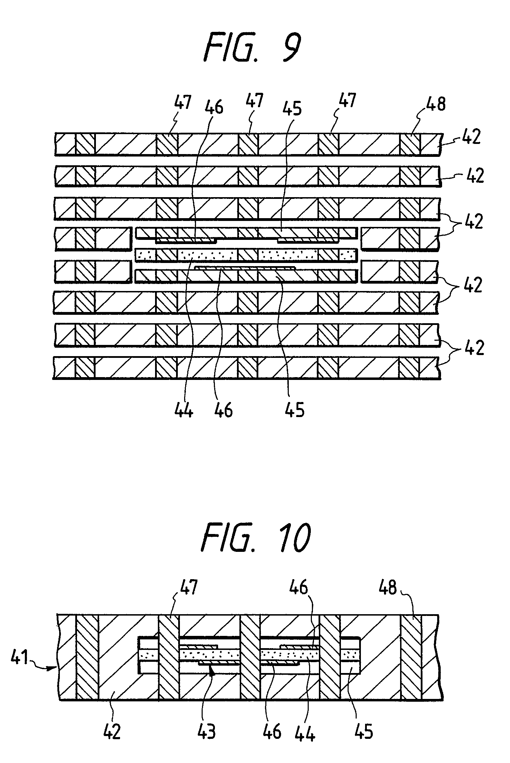

Referring now to Figs. 9 and 10, there is shown a method of making a single chip carrier 41 embodying the invention, in which, in addition to the green sheets 42 of the insulating material and the electrodes 46, there are intermediate sheets 45 on each side of the dielectric sheet 44. The function of these intermediate sheets 45 is to prevent diffusion of material of the insulator sheets 42 into the dielectric sheet 44 during the heating of the assembly, and also to prevent chemical reaction between the insulator material and the dielectric material.

The material used for the intermediate layers 45 should not react or fuse with the insulator 42 or the dielectric 44. Its melting point should exceed those of the insulator material 42 and the dielectric 44. $BaTiO_3$, MgO, $ZrO_2$, BaO, AlN, $SiO_2$, $Al_2O_3$ and mixtures thereof are suitable for the layers 45.

In more detail, the desired number of holes are made in green sheets 42 made of a ceramic insulating material. Some of these holes are for the signal conductors 48 and the rest are for the power and ground conductors 47. Similarly, holes are made in green sheets 45 of material for the intermediate layers. Likewise, holes are made in a green sheet 44 for the dielectric. The holes in the green sheets 42,44 and 45 are filled with conductor paste. A pattern for the electrodes 46 of the capacitor is printed on intermediate layer green sheets 45. Next, the sheets 42,44,45 are assembled with the holes aligned with each other. The laminate of the green sheets 42,44,45 is united by hot pressing, and the carrier 1 is formed.

A particular example of this method is given below.

EMBODIMENT 5

First, slurry for producing a green sheet 1 is made.

As a powder material, a glass powder with an average particle diameter of 5μm is composed of $SiO_2$ 70 to 80%, $B_2O_3$ 10 to 20%, $Al_2O_3$ 0 to 0.2%, $K_2O$ 0 to 5% and ZnO 0 to 0.2% in total 100%, calculated as oxide. This mixture is combined with $Al_2O_3$ powder as filler with an average grain diameter of 1μm. The amount of the glass powder is 90 to 60% and the amount of $Al_2O_3$ powder 10 to 40%. A binder made of phthalic acid (20 parts), trichloroethylen (124 parts), tetrachloroethylene (32 parts) and n-butyl alcohol (44 parts) is added to this powder and mixed in a ball mill for 24 hours to make the slurry. Next, the slurry is adjusted to an appropriate viscosity by a vacuum deaeration process. The slurry is then applied onto a polyester film, on which silicone is coated, to a thickness of 0.2 mm using a doctor blade. The film dries to form the green sheet for the insulating material. The required number of sheets 42 are thus made.

By a method as above, a green sheet 44 with a thickness of 50μm is made for the dielectric material. The dielectric material is ceramic, with a dielectric constant of about 15000. It is mainly composed of PbO, $Fe_2O_3$, $WO_3$, $TiO_2$ and $Nb_2O_5$.

Similarly, green sheets with a thickness of 50μm are made for the intermediate layers 45. $BaTiO_3$ is the primary component for this material. $BaTiO_3$ is fired normally at 1300° to 1400°C but not in this example.

Then holes with a diameter of 150μm are made as shown in Fig. 9 in the green sheets 42,44,45. The holes are filled with an Ag-Pd conductor paste 47,48 having a Pd content of 15% to 30% and a viscosity suitably adjusted for the purpose. Patterns for the electrodes 6 of the capacitor are printed on the intermediate layer green sheets 45 using the Ag-Pd conductor paste with a Pd content of 15% to 30%. After natural drying, dielectric green sheet 4 is put between the green sheets of the intermediate layers and the central area of insulator green sheets 2. Apertured insulator sheets 42 with the same thickness as the sandwiched dielectric and intermediate layers 44,45 surround the latter. The assembly is pressed by a hot press method. The pressure is 50 kgf/cm². The temperature is raied by less than 100°C/h to remove the binder, and after degreasing at 500°C for 3 h, it is raised by 200°C/h and fired at 850° to 900°C. It is fired in air.

The electrostatic capacitance of the capacitor 43 formed at the centre of the carrier substrate 41 is about 0.3μF, and the thickness of the dielectric 44 is 40μm. Diffusion of the insulator material was not found in the built-in capacitor, and nor were there cracks or peeling off around it. Also, there was no warpage or deformation of the carrier substrate 41. The total thickness of the carrier is 1 mm, and the through hole diameter is 120μm.

In an alternative form of embodiment 5 just described, two additional green sheets of the dielectric material are provided, one on each side of the dielectric sheet 44 and between the dielectric sheet 44 and the intermediate sheet 45 of BaTiO$_3$. These additional green sheets of dielectric material, not the sheets 45, carry the electrode patterns adjacent the sheet 44. In this case, no diffusion of oxide, particularly PbO, out of the dielectric sheet 44 occurs during firing so that the desired composition of this sheet is accurately maintained, giving the desired dielectric constant. In a further modification of this alternative, the sheets 45 are omitted.

**Claims**

1. A ceramic semiconductor chip carrier for carrying a single chip (15) and having a built-in capacitor (3;43) providing capacitance between conductor lines comprising power, ground and signal lines (6,7;47,48) for the chip extending through the carrier, said capacitor being formed by at least one dielectric layer (4;44) and electrodes (5;46) embedded in the carrier, said power and ground lines (4;47) passing through said dielectric layer (4;44) making contact therewith and being connected to said electrodes (5;46) at the faces of the dielectric layer so that the capacitance is between the power lines and the ground lines, characterized in that said signal lines (7;48) extend past the dielectric layer (4;44) without contacting it at locations spaced laterally from it.

2. A semiconductor chip carrier according to claim 1 having a ceramic insulator body (2;42) in which said capacitor layer (4;44) of ceramic dielectric material is embedded remote from opposed main faces of said body (2), the electrodes (5) being electrode layers embedded in said ceramic body (2) and contacting said capacitor layer (4).

3. A semiconductor chip carrier according to claim 1 or claim 2 wherein each said signal line (7;48) is spaced laterally from said dielectric layer (4;44) by not less than 50 μm.

4. A semiconductor chip carrier according to claim 3 wherein each said signal line (7;48) is spaced laterally from said dielectric layer (4;44) by not less than 100 μm.

5. A semiconductor chip carrier according to any one of claims 1 to 4 wherein there is a single said capacitor layer(4;44).

6. A semiconductor chip carrier according to claim 5 wherein there are two said electrodes (5;46) only, respectively on opposite faces of said single capacitor layer (4;44).

7. A semiconductor chip carrier according to any one of claims 1 to 6 wherein each said conductor line (6,7;47,48) extends substantially straight through said carrier from one main face thereof to the opposite main face thereof.

8. A semiconductor chip carrier according to any one of claims 1 to 7 wherein the power and ground lines (6;47) on the one hand and the signal lines (7;48) on the other hand are grouped into respective zones as seen in plan view looking onto one main face of said carrier such that one of the following arrangements (a) and (b) applies
    a) the power and ground line zone is a central zone of the carrier surrounded by the signal line zone
    b) the signal line zone is a central area of said carrier surrounded by the power and ground line zone.

9. A semiconductor chip carrier according to any one of claims 1 to 8 wherein the dielectric constant of the capacitor layer (4;44) is at least 500.

10. A semiconductor chip carrier according to any one of claims 1 to 9 wherein the capacitance between the power lines and ground lines (6;47) is at least 0.01 μF.

11. A semiconductor chip carrier according to any one of claims 1 to 10 wherein the total number of power and ground lines (6;47) is at least 100 and the total number of signal lines (7;48) is at least 100.

12. A semiconductor chip carrier according to any one of claims 1 to 11 wherein the thickness of the capacitor layer (4;44) is not more than 10 μm.

13. A semiconductor chip carrier according to any one of claims 1 to 12 wherein the capacitance between each said signal line (7;48) and the nearest of said electrodes (5;46) thereto is not more than 0.25 pF.

14. A semiconductor chip carrier according to any one of claims 1 to 13 having a ceramic insulator body (2) of ceramic glass and sintered barrier layers (45) on each face of said dielectric layer (4) to prevent diffusion of components of the dielectric layer (4) into the ceramic glass during firing of the chip carrier.

15. A semiconductor chip carrier according to any one of claims 1 to 14 having a single semiconductor chip (15) mounted thereon and connected to said conductor lines(6,7;47,48).

16. A semiconductor chip carrier and chip according to claim 15 wherein said chip (15) is mounted on said carrier by solder elements (18) which make direct connection between electrodes of the chip and said conductor lines (6,7;47,48) at one main face of the carrier.

17. A semiconductor chip carrier and chip according to claim 15 or claim 16 wherein said chip (15) is hermetically enclosed by a ceramic housing (16) sealed to said chip carrier.

18. A semiconductor chip carrier and chip according to any one of claims 15 to 17 wherein a layer of resin (19) bonds said chip (15) to said chip carrier.

19. A semiconductor chip carrier and chip according to any one of claims 15 to 18 mounted on a wiring circuit board (22).

20. A semiconductor apparatus having a semiconductor wiring circuit board (22) carrying a plurality of semiconductor chips (15), wherein each said chip (15) is individually mounted on said circuit board by a semiconductor chip carrier (1) according to any one of claims 1 to 14.

21. A semiconductor module comprising at least one wiring circuit board (22) according to claim 20 and a housing (16) enclosing said carriers (1) and said semiconductor chips (15) thereon, said housing having means (18,27) for flow of coolant fluid to cool said chips.

22. A method of manufacture of a semiconductor chip carrier according to claim 1, comprising assembling and co-firing a plurality of green sheets (8,10;42,44,45) of ceramic material having through-holes (9) filled with conductive material (12;47,48) to form conductor lines in the finished carrier, wherein said green sheets (8,10;42,44,45) comprise

(a) at least one green sheet (10;44) of dielectric material which in the fired carrier forms a capacitor layer of said capacitor,

(b) at least two green sheets (8;42,45) of insulator material embedding said at least one green sheet of dielectric material and having a larger area than said at least one green sheet of dielectric material, whereby some of said conductor lines which are to be signal lines do not contact said dielectric material, there further being electrode-forming material (14;46) embedded in the assembled green sheets adjacent said green sheet (10;44) of dielectric material to form electrodes of said capacitor.

23. A method according to claim 22 wherein said green sheet (10;44) of dielectric material is located in the assembled green sheets remote from the edges of the green sheets (8;42,45) of insulating material.

24. A method according to claim 22 or claim 23 wherein said green sheets (8;42,45) of insulator material and said at least one green sheet (10;44) of dielectric material all have approximately the same temperatures of starting and finishing shrinkage during firing and approximately the same amount of shrinkage during firing.

25. A method according to any one of claims 22 to 24 wherein said green sheets further comprise at least two intermediate sheets (45) located adjacent respectively opposite sides of said green sheet (44) of dielectric material, to provide a barrier against diffusion of matter from the sheets of insulator material (42) into the capacitor layer (44) during firing.

26. For use in the method of any one of claims 22 to 25, a combination of green sheets (8,10;42,44,45) of ceramic material having through holes (9) filled with conductive material (12;47,48) to form conductor lines in the finished carrier, said green sheets comprising

(a) at least one green sheet (10;44) of dielectric material which in the fired carrier forms a capacitor layer of said capacitor,

(b) at least two green sheets (8;42,45) of insulator material having a larger area than said at least one green sheet (10;44) of dielectric material, such that on assembly and firing of said green sheets some conductor lines formed do not pass through said capacitor layer and other conductor lines formed do pass through said capacitor layer, said green sheets further carrying electrode-forming material (14;46) for forming electrodes adjacent said capacitor layer and contacting said conductor lines which do pass through said capacitor layer.

27. A combination of green sheets according to claim 26 wherein there are more than two said green sheets (8;42) of insulator material and two of said sheets of insulator material carry said electrode-forming material.

28. A combination of green sheets according to claim 26 further comprising at least two intermediate sheets (45) of composition different from that of said green sheets (42) of insulator material and adapted to form barrier layers to prevent diffusion of matter from said sheets of insulator material into the capacitor layer (44) during firing, said intermediate sheets (45) carrying said electrode-forming material (46)

EP 0 359 513 A2

FIG. 1a

9    9
8

FIG. 1b

12    14    14    8
12

FIG. 1c

14
8
13    14
10
11    14    13

FIG. 1d

5  3  4
1
7  2  6  5  6  7

# FIG. 2

# FIG. 3

# FIG. 4

# FIG. 5

## FIG. 6

## FIG. 7

FIG. 8

EP 0 359 513 A2

FIG. 9

47  46  47  45    47    48

42
42
42
42
42
42
42

44  46      45

FIG. 10

47        46        48

41

42    43    46 44    45